Europäisches Patentamt

European Patent Office

Office européen des brevets

(19)

(11) **EP 0 905 878 A2**

(12) **EUROPÄISCHE PATENTANMELDUNG**

(43) Veröffentlichungstag:
31.03.1999 Patentblatt 1999/13

(51) Int. Cl.⁶: **H03C 3/00**

(21) Anmeldenummer: 98117165.5

(22) Anmeldetag: 10.09.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 30.09.1997 DE 19743275

(71) Anmelder:
SIEMENS AKTIENGESELLSCHAFT
80333 München (DE)

(72) Erfinder:
• Feng, Shen, Dr.
81373 München (DE)
• Herzinger, Stefan
80686 München (DE)

(54) **Modulator zum Erzeugen eines hochfrequenten Sendesignals**

(57) Zur Reduzierung des Stromverbrauchs und des Platzbedarfs weist der erfindungsgemäße Mobilfunksender einen ersten Oszillator (LO) auf, der mit einem Quadraturmodulator (QM) verbunden ist. Dieser mischt die Basisband-Eingangssignale mit dem vom ersten Oszillator (LO) stammenden Trägersignal und führt das Ausgangssignal einem Phasenfrequenzvergleicher (PFD) zu. Dessen Ausgangssignal liegt durch einen Schleifenfilter (LF) gefiltert an einem Hochfrequenzoszillator (HF-VCO) an, der direkt das Sendesignal erzeugt, welches ebenfalls dem Phasenfrequenzdetektor (PFD) zugeführt wird.

FIG 2

**Beschreibung**

Die Erfindung betrifft einen Sender zum Erzeugen eines hochfrequenten Sendesignals, welcher beispielsweise in Mobilfunksystemen eingesetzt werden kann. Diese können unter anderem den weit verbreiteten GSM-Standard (Global System For Mobil Communication) oder den DCS1900-Standard benutzen. Die Erfindung ist jedoch nicht auf die explizit genannten Standards beschränkt, sondern kann für alle Kommunikationssysteme verwendet werden, bei denen die Modulation des Datensignals derart erfolgt, daß dessen Amplitude beibehalten wird.

Das GSM-Netz besteht, wie jedes andere Telekommunikationsnetz auch, aus Systembestandteilen, die Schnittstellen bedienen und Funktionalitäten bereitstellen. Es arbeitet in den Frequenzbereichen 890 MHz bis 950 MHz und 935 MHz bis 960 MHz. Das Netz ist aus einer Vielzahl von Funkstellen aufgebaut. Die Anzahl der modular einsetzbaren Grundbausteine im GSM-Netz ist jedoch verhältnismäßig gering. Das Base-Station-Sub-System (Basisstationsteilsystem) organisiert den sicheren Datenaustausch zwischen den Mobilstationen und der Netzinfrastruktur. Dazu gehören Aufbau, Aufrechterhaltung und Aufbau der Funkverbindung zwischen Mobilstationen und der Base-Tranceiver-Station (Basisstation). Darüber hinaus wird eine ständige Qualitätsbeurteilung des Funkkanals und die daraus abzuleitenden Reaktionen des Systems z.B. die Einleitung und Steuerung von Zellwechseln (Hand-Over) vorgenommen. Außerdem werden Informationen über den Aufenthaltsort der Mobilstationen an das Netz weitergegeben. Das vermittlungstechnische Teilsystem (Switching-Subsystem) führt zum einen alle Aufgaben aus, die zum Aufbau, Verwalten und Lösen von Verbindungen benötigt werden. Zum anderen muß das vermittlungstechnische Teilsystem aber auch alle mobilitätsbedingten Verfahren durchführen. Dies reicht von der Verwaltung der statischen Teilnehmerdaten über das Auffinden einer gerufenen Mobilstation an einem beliebigen Ort des GSM-Versorgungsbereichs bis zur zuverlässigen Erfassung aller Gebührendaten. Daneben bedient das vermittlungstechnische Teilsystem Schnittstellen zu anderen Telekommunikationsnetzen oder Telekommunikationsdiensten.

Die Funkstrecke zwischen dem Mobilteil und der Netzinfrastruktur ist von zwei Grundeigenschaften geprägt: Die Ressource Funkkanal ist nur eingeschränkt verfügbar. Sie kann prinzipiell an einem Ort zur selben Zeit nur einmal verwendet werden. Jeder Funkkanal ist hochgradig störanfällig. Das Auftreten von Störungen in diesen offenen Systemen kann nicht unterbunden werden. Auf einem physikalischen Funkkanal werden zeitgeteilt acht physikalische Nachrichtenkanäle, genannt Bursts, übertragen. Eine vollständige Sequenz aller acht Kanäle wird TDMA-Rahmen (Time-Devision-Multible-Access) genannt. Auf jedem physikalischen Nachrichtenkanal können Signalisierungs- und/oder Nutzinformationen auf sogenannten logischen Kanälen vermittelt werden. Die Zuordnung von logischen auf physikalische Kanäle wird als Mapping bezeichnet. Das Mapping ist dynamisch und wechselt in Abhängigkeit von Betriebszustand und zu realisierender Übertragungsaufgabe, z.B. bei der Übertragung von Sprachinformationen über den Normalburst bei bestehender Telefonverbindung. Die logischen Kanäle bestehen aus den Verkehrskanälen und den Steuer- oder Kontrollkanälen.

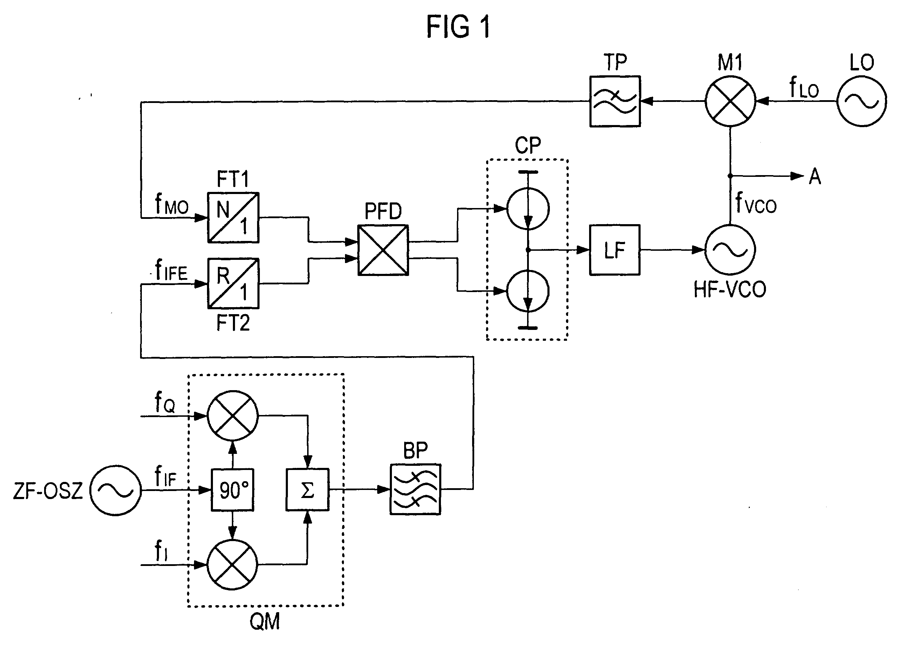

Um das Signal über die Luftschnittstelle zu übertragen, ist ein Sender notwendig, der das Datensignal im Basisband so aufbereitet, daß es über die Luftschnittstelle übertragbar ist. Dabei dürfen keine Konflikte mit anderen zu übertragenden Informationen, die von anderen Funksystemen stammen, entstehen. Eine Voraussetzung für eine gute Sendesignalqualität ist ein niedriger Rauschpegel weitab vom Träger bei hoher Sendeleistung. Dazu ist aus dem Stand der Technik ein in Figur 1 gezeigter Sender bekannt. Dieser weist einen lokalen Oszillator LO, der zur Kanaleinstellung dient, auf. Das vom lokalen Oszillator LO stammende Signal mit der Frequenz fLO wird mit einem Sendesignal der Frequenz fVCO, welches von einem Hochfrequenzoszillator HF-VCO stammt mittels eines Mischers M1 gemischt und einem Tiefpaß TP zugeführt. Das am Ausgang des Tiefpasses TP anliegende Signal mit der Frequenz fMO wird auf einen ersten Frequenzleiter FT1 mit dem Teilerwert N geführt, welcher das Signal mit der Frequenz fMO den Teilerwert N teilt und einen Phasenfrequenzvergleicher PFD zuführt. Ein Quadraturmodulator QM mischt das Inphase-Datensignal mit der Frequenz fI und das Quadratur-Datensignal mit der Frequenz fQ jeweils mit einem von einem Zwischenfrequenzoszillator ZF-OSZ stammenden Signal (Frequenz fIF) und addiert die entsprechenden Mischerausgangssignale auf. Das so gewonnene quadraturmodulierte Signal mit der Frequenz fIFE wird durch den Bandpaß BP gefiltert und einem zweiten Frequenzteiler FT2 mit dem Teilerverhältnis R zugeführt. Der zweite Frequenzteiler FT2 teilt das Signal mit der Frequenz fIFE durch den Teilerwert R und führt das geteilte Signal auf den Phasenfrequenzvergleicher PFD. Dieser vergleicht anfänglich die an dessen Eingängen anliegenden Frequenzen und später deren Phasen miteinander. Der Phasenfrequenzvergleicher PFD erzeugt entsprechende Steuerausgangssignale, üblicherweise in Form von Nadelimpulsen, welche einer Ladungspumpe CP zugeführt werden. Die Ladungspumpe CP in Verbindung mit einem passiven Schleifenfilter LF wirkt wie ein aktives Schleifenfilter. Das am Ausgang des Schleifenfilters LF anliegende Signal steuert den Hochfrequenzoszillator HF-VCO, welcher dann direkt das Sendesignal mit der Frequenz fVCO erzeugt, das am Ausgang A des Senders abgreifbar ist.

Die beschriebene Schaltung hat zwei gravierende Nachteile. Erstens weist das vom Mischer M1 erzeugte Signal einen hohen Störsignalanteil auf, weil sowohl der Hochfrequenzoszillator HF-VCO, als auch der Lokaloszillator LO einen nicht unerheblichen Klirrfaktor aufweisen, d.h. sie erzeugen Signale mit einer Grundfrequenz und mehreren Harmonischen dazu. Zusätzlich wird beim Wechseln der Frequenz fLO von einer ersten auf eine zweite Kanalfrequenz ein gegenüber dem ersten Mischprodukt verschiedenes Mischprodukt entstehen, was bedeutet, daß am Mischerausgang neue, veränderte Störsignalanteile auftreten. Die Frequenzen der Störsignalanteile können zudem sehr nahe bei der Sendefrequenz fVCO liegen. Zweitens können Störungen vom Phasenfrequenzvergleicher PFD ausgehen, wobei diese frequenzmäßig ebenfalls in der Näher der Sendefrequenz fVCO liegen können.

Eine Aufgabe der Erfindung ist es, einen Sender anzugeben, bei dem die im Stand der Technik auftretenden Störungen vermieden werden.

Die Aufgabe wird durch einen Sender gemäß Patentanspruch 1 gelöst.

Der erfindungsgemäße Sender zum Erzeugen eines hochfrequenten Signals weist einen ersten Oszillator, einen Quadraturmodulator, einen Vergleicher, ein erstes Filter, einen zweiten Oszillator und mindestens einen Frequenzteiler auf. Der Ausgang des ersten Oszillators ist mit dem ersten Eingang des Quadraturmodulators verbunden. Am zweiten und dritten Eingang des Quadraturmodulators liegen Basisband-Eingangssignale an. Der Ausgang des Quadraturmodulators ist mit dem ersten Eingang des Vergleichers und der Ausgang des Vergleichers mit dem Eingang des ersten Filters und der Ausgang des ersten Filters mit dem Eingang des zweiten Oszillators verbunden. Der Ausgang des zweiten Oszillators, an dem auch das hochfrequente Sendesignal anliegt, ist mit dem Vergleicher verbunden. Zwischen den zweiten Oszillator und den Vergleicher und/oder zwischen den Quadraturmodulator und den Vergleicher ist der Frequenzteiler geschaltet.

Vorteilhafterweise wird für die erfindungsgemäße Schaltung weniger Chipfläche benötigt. Ein weiterer Vorteil besteht darin, daß durch die starre Frequenzkopplung, unabhängig von der Kanalfrequenz, eine eventuell auftretende Störung immer exakt mit der Sendefrequenz zusammenfällt, was dann unproblematisch ist.

Vorteilhafte Weiterbildungen ergeben sich aus den abhängigen Ansprüchen.

So ist in einer Ausführungsform ein zweites Filter vorgesehen, das dem Quadraturmodulator nachgeschaltet ist.

Weiterhin kann eine Ladungspumpe vorgesehen sein, die dem ersten Filter vorgeschaltet ist.

Der Vergleicher kann auch zum Frequenzvergleich dienen.

Der Sender ist für ein Mobilfunksystem verwendbar.

Die Erfindung wird im folgenden anhand von vier Figuren weiter erläutert.

Figur 1    zeigt einen Sender wie er aus dem Stand der Technik bekannt ist.

Figur 2    zeigt das Blockschaltbild eines erfindungsgemäßen Senders.

Figur 3    zeigt die Frequenzlagen im oberen und unteren Seitenband beim Sender gemäß Figur 1.

Figur 4    zeigt die Frequenzlagen im oberen und unteren Seitenband beim erfindungsgemäßen Sender gemäß Figur 2.

Auf Figur 1 wurde bereits oben eingegangen.

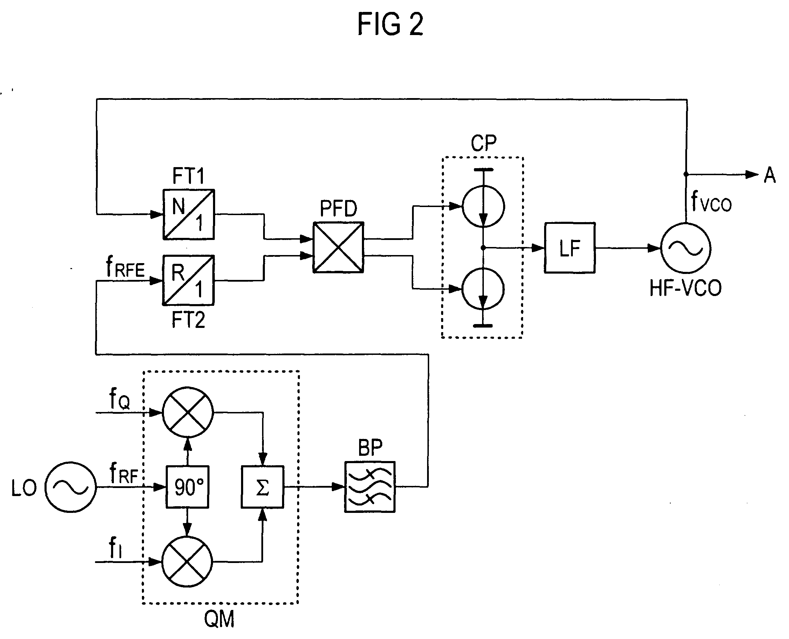

Gegenüber dem in Figur 1 gezeigten Blockschaltbild wurde bei dem in Figur 2 gezeigten Sender erstens der Zwischenfrequenzoszillator ZF-OSZ entfernt und zweitens der Mischer M1 und der Tiefpaß TP entfernt und drittens der lokale Oszillator LO mit dem Eingang des Quadraturmodulators QM verbunden.

Der Begriff „verbunden" bedeutet im gesamten Kontext, daß die einzelnen Schaltungselemente entweder direkt oder aber unter Zwischenschaltung eines oder mehrerer weiterer Schaltungselemente mit dem zweiten Schaltungselement verknüpft sind. Der Begriff „verbunden" soll sowohl eine funktionelle als auch eine physikalische Verbindung zwischen den einzelnen Schaltungselementen umfassen.

Der erfindungsgemäße Sender für Zellularsysteme erreicht mit geringem Schaltungsaufwand und bei geringem Stromverbrauch ein geringeres Breitband-Ausgangsrauschen, erzeugt wenigere unerwünschte Ausgangssignalanteile (z.B. durch unerwünschte Mischprodukte) und die Ausgangsphase folgt genauer dem gewünschten Modulationsschema als der Sender gemäß dem Stand der Technik (Figur 1).

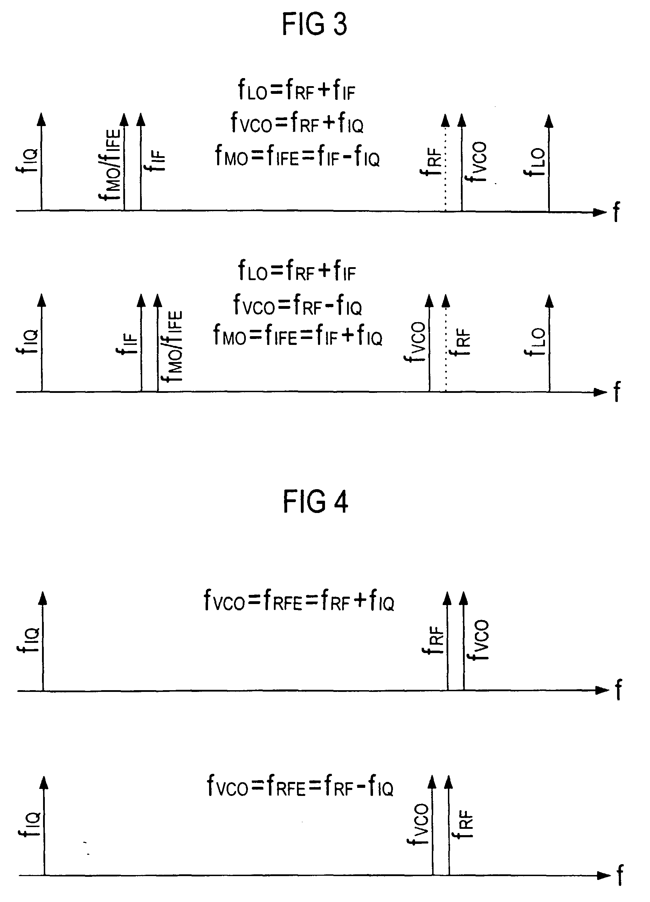

Die Frequenzlagen des Senders gemäß Figur 1 sind in Figur 3 gezeigt. Auf den Abszissen der beiden Diagramme ist jeweils die Frequenz f und auf den Ordinaten die Amplitude angetragen. Im oberen Diagramm der Figur 3 ist das obere Seitenband, im unteren Diagramm der Figur 3 das untere Seitenband gezeigt. Die Frequenz fVCO des Sendesignals im oberen Seitenband ergibt sich aus

$$fVCO = fRF + fIQ$$

Im unteren Seitenband gilt:

$$fVCO = fRF - fIQ$$

wobei

fRF =    Trägerfrequenz des Trägersignals

fIQ =    Frequenz des Basisbandeingangssignals

Die Frequenz fLO des vom lokalen Oszillators LO stammenden Signals ergibt sich im oberen und unteren Seitenband zu:

$$fLO = fRF + fIF$$

wobei

fIF die Frequenz des vom Zwischenfrequenzoszillator ZF-OSZ stammenden Signals ist.

Die Frequenz fMO ist im Idealfall gleich der Frequenz fIFE, welche die Frequenz des bandpaßgefilterten Ausgangssignals des Quadraturmodulators QM ist.

Im oberen Seitenband ergibt sich fIFE zu:

$$fIFE = fIF - fIQ$$

Im unteren Seitenband ergibt sich fIFE zu:

$$fIFE = fIF + fIQ$$

Insgesamt treten im oberen Seitenband jeweils in zunehmender Reihenfolge die Frequenzen fIQ, fMO/fIFE, fIF, fRF, fVCO und fLO auf. Im unteren Seitenband treten die Frequenzen in aufsteigender Reihenfolge wie folgt auf: fIQ, fIF, fMO/MfIFE, fVCO, fRF und fLO.

Gegenüber dem in Figur 3 gezeigten Frequenzspektrum tauchen bei dem in Figur 4 gezeigten oberen und unteren Seitenband nur mehr die Frequenzen fIQ, fRF und fVCO auf. Die Aufzählung entspricht dem Auftreten der Frequenzen in aufsteigender Reihenfolge im oberen Seitenband. Im unteren Seitenband treten die Frequenzen in aufsteigender Reihenfolge wie folgt auf: fIQ, fVCO und fRF.

Im Fall, daß keine Regeldifferenz auftritt, ist die Frequenz fVCO des vom HF-Oszillators HF-VCO stammenden Signals mit der Frequenz fVCO gleich der Frequenz fRFE. Die Frequenz fRFE ergibt sich im oberen Seitenband zu:

$$fRFE = fRF + fIQ$$

Im unteren Seitenband ergibt sich die Frequenz fRFE zu:

$$fRFE = fRF - fIQ.$$

In Figur 3 ergibt sich die Frequenz fVCO im unteren Seitenband zu

$$FVCO = fRF - fIQ.$$

Bei der in Figur 1 gezeigten Schaltungsanordnung werden der Quadraturmodulator QM, die Frequenzteiler FT1 und FT2, der Phasenfrequenzdetektor PFD, die Ladungspumpe CP und der Schleifenmischer M1 auf einem integrierten Schaltkreis realisiert. Das Tiefpaßfilter TP, das Bandpaßfilter BP, das Schleifenfilter LF und der Hochfrequenzoszillator HFVCO sind externe Schaltungselemente.

Die in Figur 1 gezeigte Schaltungsanordnung hat den Nachteil, daß ein Zwischenfrequenzoszillator ZF-OSZ mit einem Frequenzsynthesizer für die Erzeugung des Zwischenfrequenzoszillatorausgangssignals mit der Frequenz fIF und ein lokaler Oszillator LO mit einem Frequenzsynthesizer für die Erzeugung des Signals mit der Frequenz fLO für die Kanaleinstellung notwendig sind.

Bei der in Figur 2 gezeigten erfindungsgemäßen Schaltungsanordnung fällt vor allem gegenüber dem Sender gemäß dem Stand der Technik in Figur 1 der Schleifenmischer M1, das entsprechende Tiefpaßfilter TP und der Zwischenfrequenzoszillator ZF-OSZ mit dem Frequenzsynthesizer für die Erzeugung des Signals mit der Frequenz fIF weg.

Der lokale Oszillator LO in Figur 2 erzeugt ein Trägersignal mit der Trägerfrequenz fRF. Bei dem in Figur 2 gezeigten Sender existieren keine unerwünschten Mischprodukte durch den Schleifenmischer M1, es wird der Schaltungsaufwand reduziert und die gesamte Stromaufnahme des Senders wird wesentlich verringert.

Mit gleichen Teilerfaktoren N und R arbeitet der Quadraturmodulator QM mit der HF-Trägerfrequenz fRF und die Phase- und Frequenzlage am Quadraturmodulatorausgang (fIFE) sind gleich wie am Senderausgang A, wenn keine Regeldifferenz auftritt.

Die Teilerfaktoren N und R können auch unterschiedlich eingestellt werden, falls ein Skalierungsfaktor von R/N für die I/Q-Signale im Basisband und für das Trägersignal mit der Trägerfrequenz fRF im Zwischenfrequenzoszillator ZF-OSZ implementiert wird. Da das breitbandige Ausgangsrauschen durch den Regelkreis in Form einer PLL (Phase Looked Loop) stark unterdrückt wird, ist das Hochfrequenzbandpaßfilter BP am Ausgang des Quadraturmodulators QM auch mit geringem Schaltungsaufwand realisierbar.

Der neue Sender hat somit unter anderem folgende Vorteile. Prinzipbedingt treten keine unerwünschten Mischprodukte mehr auf, der Schaltungsaufwand wird reduziert und die Stromaufnahme durch den Wegfall des Zwischenfrequenzoszillators ZF-OSZ, der das Signal mit der Frequenz fIF erzeugt, reduziert. Ebenso wird die Stromaufnahme durch Wegfall des Schleifenmischers M1 und des entsprechenden Tiefpaßfilters TP verringert.

Der Hochfrequenzoszillator HF-VCO ist ein spannungsgesteuerter Oszillator. Der lokale Oszillator LO kann ebenfalls ein spannungsgesteuerter Oszillator sein.

**Patentansprüche**

1.  Sender zum Erzeugen eines hochfrequenten Sendesignals,

    -   bei dem ein erster Oszillator (LO), ein Quadraturmodulator (QM), ein Vergleicher (PFD), ein erstes Filter (LF), ein zweiter Oszillator (HF-VCO) und mindestens ein Frequenzteiler (FT1, FT2) vorgesehen sind,
    -   bei dem der Ausgang des ersten Oszillators (LO) mit dem ersten Eingang des Quadraturmodulators (QM) verbunden ist,
    -   bei dem am zweiten und dritten Eingang des Quadraturmodulators (QM) Basisband-Eingangssignale anliegen,
    -   bei dem der Ausgang des Quadraturmodulators (QM) mit dem ersten Eingang des Vergleichers (PFD) verbunden ist,
    -   bei dem der Ausgang des Vergleichers (PFD) mit dem Eingang des ersten Filters (LF) verbunden ist,
    -   bei dem der Ausgang des ersten Filters (LF) mit dem Eingang des zweiten Oszillators (HF-VCO) verbunden ist,
    -   bei dem der Ausgang des zweiten Oszillators (HF-VCO), an dem das hochfrequente Sendesignal anliegt, mit dem zweiten Eingang des Vergleichers (PFD) verbunden ist,
    -   bei dem zwischen den zweiten Oszillator (HF-VCO) und den Vergleicher (PFD) oder/und zwischen den Quadraturmodulator (QM) und den Vergleicher (PDF) der Frequenzteiler (FT1, FT2) geschaltet ist.

2.  Sender nach Anspruch 1,
    bei dem ein zweites Filter (BP) vorgesehen ist, das dem Quadraturmodulator (QM) nachgeschaltet ist.

3.  Sender nach einem der Ansprüche 1 oder 2,
    bei dem eine Ladungspumpe (CP) vorgesehen ist, die dem ersten Filter (LF) vorgeschaltet ist.

4.  Sender nach einem der Ansprüche 1 bis 3,
    bei dem der Vergleicher (PFD) auch zum Frequenzvergleich dient.

5.  Sender nach einem der Ansprüche 1 bis 4,
    für ein Mobilfunksystem.

FIG 1

# FIG 2

EP 0 905 878 A2

# FIG 3

$$f_{LO}=f_{RF}+f_{IF}$$
$$f_{VCO}=f_{RF}+f_{IQ}$$
$$f_{MO}=f_{IFE}=f_{IF}-f_{IQ}$$

$f_{IQ}$  $f_{MO}/f_{IFE}$  $f_{IF}$  $f_{RF}$  $f_{VCO}$  $f_{LO}$  $f$

$$f_{LO}=f_{RF}+f_{IF}$$
$$f_{VCO}=f_{RF}-f_{IQ}$$
$$f_{MO}=f_{IFE}=f_{IF}+f_{IQ}$$

$f_{IQ}$  $f_{IF}$  $f_{MO}/f_{IFE}$  $f_{VCO}$  $f_{RF}$  $f_{LO}$  $f$

# FIG 4

$$f_{VCO}=f_{RFE}=f_{RF}+f_{IQ}$$

$f_{IQ}$  $f_{RF}$  $f_{VCO}$  $f$

$$f_{VCO}=f_{RFE}=f_{RF}-f_{IQ}$$

$f_{IQ}$  $f_{VCO}$  $f_{RF}$  $f$

8